Europäisches Patentamt

European Patent Office

Office européen des brevets

(11) Publication number: **0 307 272**
**A2**

# EUROPEAN PATENT APPLICATION

(21) Application number: 88402131.2

(22) Date of filing: 19.08.88

(51) Int. Cl.⁴: **H 01 L 23/52**

(30) Priority: 09.09.87 US 94936

(43) Date of publication of application:
15.03.89 Bulletin 89/11

(84) Designated Contracting States: DE FR GB IT

(71) Applicant: SGS-THOMSON MICROELECTRONICS, INC.
(a Delaware corp.)
1310 Electronics Drive
Carrollton, TX 75006 (US)

(72) Inventor: Farahani, Mohammad M.
Cabinet Ballot-Schmit 84 avenue Kléber
F-75116 Paris (FR)

Eng, Lawrence P.
Cabinet Ballot-Schmit 84 avenue Kléber
F-75116 Paris (FR)

Turner, Timothy E.
Cabinet Ballot-Schmit 84 avenue Kléber
F-75116 Paris (FR)

(74) Representative: Ballot, Paul Denis Jacques
Cabinet Ballot-Schmit 84, avenue Kléber
F-75116 Paris (FR)

(54) Aluminum alloy semiconductor interconnections having high purity titanium or niobium barrier layer.

(57) The invention provides a device comprising an oxidized
silicon substrate and an aluminum or aluminum alloy conductive
path on said substrate, said conductive path being substantially
completely separated from said substrate by a layer of
substantially pure titanium or niobium along the length of the
conductive path, said titanium or niobium being in direct
contact with both said aluminum or aluminum alloy path and
said silicon substrate. The invention further describes the
application of this barrier layer of niobium or titanium to
semiconductor circuits which require the use of multiple layers
of conductive pattern.
    The invention further provides a method for producing a
semiconductor device of the type described above.

## Description

### Aluminum alloy semiconductor interconnections having high purity titanium or niobium barrier layer.

The invention relates to methods of providing a barrier metal between a aluminum metalization layer and the silicon substrate for a semiconductor device.

By far, the metal element most commonly used in the semiconductor industry for metal interconnects is aluminum.

The choice of aluminum is due to its several advantages including ease of deposition, low resistivity, and since it makes an ohmic contact with silicon.

Unfortunately, aluminum also has a few drawbacks. Aluminum is easily corroded in either an acidic or basic environment. The self passivation layer of oxide grown on bulk material which allows it to be used in many applications cannot be applied to thin films of the material which must retain its low resistivity. The recrystallization temperature for aluminum is only slightly above 100 degrees C. This allows self diffusion of aluminum under high stress conditions at temperatures well within the typical use conditions for most semiconductors. Both high current density and high mechanical stress failures of aluminum and aluminum alloys are known for semiconductors. Additionally, at high processing temperatures, aluminum thin films grow hillocks. These hillocks can crack the passivation glass layers short adjacent interconnections, or short through the interlevel passivation on multilevel circuits.

Furthermore, the sputter or evaporation deposition techniques typically used to apply the metal to the surface of the semiconductor are susceptible to a self shadowing phenomena. This can substantially reduce the thickness of an aluminum film where it crosses steps on the top surface of the semiconductor. Al and Al alloys are difficult to use with double level metal processes which involve vias less than 1.5 microns in diameter. It is also difficult to obtain a good low resistance metallurgical contact between the two metal levels due to the formation of an insulating oxide layer on the first aluminum layer. Additionally, the second level of Al can be easily oxidized during the initial phase of the deposition due to outgassing of moisture during the deposition.

Also, aluminum has an affinity for silicon during the sintering process which results in the aluminum pitting through and shorting out shallow junctioned devices. This problem has been solved by using aluminum alloys containing silicon. While this solves the pitting problem, it causes difficulties with thin film step coverage as well as formation of silicon precipitates at contacts and vias and hillocks. When the aluminum silicon layer has been etched to define the metalization interconnect pattern, the silicon in the alloy is left behind in the form of small nodules. These produce a very rough surface resulting in a topography which is very difficult to cover with another layer of metal. The problem can be further complicated by the precipitation of silicon particles which could cause the fracture of metal interconnection patterns and increase contact and via resistance. These cause reliability problems as well as yield problems.

A solution to this problem has been to use non-silicon containing alloys of aluminum together with a barrier metal between the aluminum and the silicon substrate to prevent alloy pitting. The prior art has suggested the use of a titanium-tungsten alloy for such a barrier layer.

Unfortunately, titanium-tungsten makes good ohmic contact to N type silicon but not to P type. Past processes utilizing titanium-tungsten have, therefore, necessitated the use of an extra photolithographic masking operation, making the process more complex and costly. That is, in the past, the titanium-tungsten layer has to be defined by photolithographic means and then etched from the P type contact windows prior to depositing the aluminum metalization layer. This technology has been used in bipolar semiconductors very successfully, however, it cannot be applied to CMOS products because of the high P type Si contact resistance.

The prior art has used tungsten as an interconnection layer. This avoids several of the discussed problems with aluminum but does not make an ohmic contact with P type silicon, and is approximately 7 times as resistive as aluminum.

Other barrier layers under aluminum have also been proposed including several silicides of the refractory metals. Most of these have been rejected because of the complicated techniques for the application of these films.

These problems become increasingly worse as semiconductor geometries are reduced.

Additionally, the use of a niobium barrier layer allows a degree of control over the surface reflectance of the subsequently applied aluminum or aluminum alloy film. Surface reflectivity is very important to most patterning techniques. If the layer is too reflective, then the light used to project the image onto the photosensitive material used to pattern the metal will be reflected into the areas not intended for exposure. It has been observed that the surface reflectance of aluminum or aluminum alloy films deposited over nitride can be adjusted by changing the deposition temperature of the aluminum. This effect has not been observed with the deposition of aluminum other than onto silicon dioxide or onto titanium.

The present invention provides a solution to the above problem by applying a layer of substantially pure titanium or niobium as a barrier conductors and the silicon aluminum or aluminum alloy conductors and the silicon substrate. The present invention describes two materials which have been found to solve the problems previously described. Either can be used in most applications, however, niobium has been found to be the material of choice for applications which require high post metal deposition processing temperature, or high temperature applications. This is due to the fact that aluminum will alloy with titanium to form an $TiAl_3$ intermetallic layer.

When this layer totally consumes the Ti layer, the TiAl$_3$ layer will allow silicon aluminum to interdiffuse and can cause a short circuit through an underlying junction.

The invention provides a device comprising an oxidized silicon substrate and an aluminum or aluminum alloy conductive path on said substrate, said conductive path being substantially completely separated from said substrate by a layer of substantially pure titanium or niobium along the length of the conductive path, said titanium or niobium being in direct contact with both said aluminum or aluminum alloy path and said silicon substrate. The invention further describes the application of this barrier layer of niobium or titanium to semiconductor circuits which require the use of multiple layers of conductive patterns. In this application, the invention provides a device comprising an oxidized silicon substrate and two stacked aluminum or aluminum alloy conductive paths on said substrate, the lower conductive path being substantially completely separated from said substrate by a layer of substantially pure titanium or niobium along the length of the conductive path, said titanium or niobium being in direct contact with both said aluminum or aluminum alloy path and said silicon substrate, said upper conductive path being separated from the first conductive path b a layer of suitable dielectric such as silicon dioxide, and another layer of titanium or niobium, said layer of titanium or niobium being in direct contact with both sad aluminum or aluminum alloy conductive layer and said suitable dielectric layer.

The invention further provides a method for producing a semiconductor device which comprises providing a silicon containing substrate having circuit elements thereon and an insulating layer over said substrate and circuit elements, which insulating layer has contact openings therethrough corresponding to the circuit elements ; providing a patterned conductive path of substantially pure titanium or niobium on said insulating layer which connect with said circuit elements through the said contact openings ; and forming a substantially congruent patterned conductive path of aluminum of aluminum alloy on said titanium or niobium conductive path ; said aluminum being substantially completely separated from said substrate and said insulating layer.

In accordance with the invention, a silicon semiconductor substrate having a plurality of circuit elements is provided. The substrate is then provided with a suitable insulating layer, such as one of silicon dioxide in which contact openings have been made in the usual fashion. The upper surface of this layer is then deposited with a conductive barrier layer of substantially pure titanium or niobium such that the appropriate conductive paths are formed with the circuit elements through the contact openings.

The titanium may be applied for example, by sputtering or by vapor deposition in the usual fashion by a method well known to the skilled artisan. Thereby a thin layer of titanium or niobium, having a thickness of from about 500 to about 2 000 angstroms is formed. An aluminum alloy layer is similarly deposited by conventional sputtering on the said barriers and both layers are etched to define the desired interconnection pattern. This aluminum layer preferably has a thickness of from about 4000 to about 15 000 angstroms. In the preferred embodiment the aluminum layer is substantially silicon free and may contain up to about 4.0% by weight copper. A more preferred range for the copper content is from about .25 to about 2.0% by weight. In one particularly preferred embodiment the copper content is about .5% by weight of the alloy.

It has been found the barrier layer makes an ohmic contact with Si substrate nearly as good as that of aluminum alloys. The resistance of the said barriers can be as high as twenty times that of Al in a thin film, but the layered structure of aluminum over the said barrier provides a line resistance nearly identical to that of an aluminum alloy alone.

Titanium or niobium are essentially not affected by basic solutions, and are much less susceptible to electrolytic corrosion in a mildly acidic solution. This effect may be demonstrated by placing two unpassivated aluminum thin film pads (4 mils x 4 mils) under common tap water. An electrical bias is then applied between the pads via gold wires thermosonically bonded to the center of each pad. The aluminum alloy pads are corroded away in less than 45 seconds. Similarly processed pads with a thin (1500 angstroms) layer of Ti under the 15000 angstroms layer of an aluminum .5% copper alloy last more than two hours before the gold wire lifts from the remaining Ti pad.

The recrystallization temperatures for Ti or niobium are above 900 degrees centigrade. Therefore, it is essentially not susceptible to self diffusion at temperatures normally experienced in the use of semiconductors. Thus titanium and niobium are essentially not susceptible to electromigration or stress cracking. This is significant in this layered structure because in the event that the top layer of aluminum opens under high stress conditions, the barrier layer can still conduct the current through the line. Additionally, since the cracks opened in the aluminum are typically small relative to the length of an interconnecting line, the resistance increase provided by the underlying barrier bridge will not be a significant increase in the total line resistance.

A niobium barrier layer can also be used to control the reflectivity of the subsequently applied aluminum or aluminum alloy conductive pattern. Once the barrier layer is deposited, the deposition temperature of the aluminum or aluminum alloy can be adjusted to obtain a range of surface reflectivity from 89% to 95%. Surface reflectivity is very important to most common techniques for patterning the narrow metal patterns used on semiconductors. Control of surface reflectivity in this way is not possible without the use of the niobium barrier layer.

A further application of this barrier layer is to application requiring more than one conductive layer. In accordance with this invention, a silicon semiconductor substrate having a plurality of circuits elements is provided with a suitable insulating layer, contact openings and a conductive pattern applied. The substrate and conductive pattern are then provided with another suitable insulating layer such as silicon dioxide, and the contact openings are again made in the usual manner. The upper surface of this layer is then deposited with a conductive barrier layer of substantially pure titanium or niobium such that the appropriate conductive paths are formed with the underlying conductive pattern. The titanium or niobium may be applied by sputtering or by vapor deposition in the usual manner by a method known to the skilled artisan. Thereby a thin layer of titanium or niobium, having a thickness of about 500 to about 2000 angstroms is formed. An aluminum or aluminum alloy layer is similarly deposited by conventional sputtering or other vapor deposition technique. Both layers are then etched simultaneously to define the desired interconnection pattern. This aluminum or aluminum alloy layer preferably has a thickness of from 4 000 to 15 000 angstroms. In the preferred embodiment, the aluminum layer is substantially free of silicon and may contain up to about 4 % by weight copper. A more preferred range for the copper content is from about .25 % to about 2.0% by weight. In one particularly preferred embodiment, the copper content is about .5 % by weight of the alloy.

It has been found that the barrier layer of titanium or niobium makes an ohmic contact to aluminum or aluminum alloys that is not affected by thin layers of aluminum oxide on the surface of the lower aluminum or aluminum alloy conductive pattern.

**Claims**

1 - A semiconductor device comprising a silicon substrate and an aluminum or aluminum alloy conductive path on said substrate, said conductive path being substantially completely separated from said substrate by a layer of substantially pure titanium or niobium along the length of the conductive path, said titanium or niobium being in direct contact with both said aluminum or aluminum alloy path and said silicon substrate.

2 - The device of claim 1 wherein said aluminum alloy is substantially silicon free.

3 - The device of claim 1 wherein said titanium or niobium layer has a thickness of from about 500 to about 2000 angstroms.

4 - The device of claim 1 wherein said aluminum or aluminum alloy has a thickness of from about 4000 to about 15 000 angstroms.

5 - The device of claim 1 wherein said aluminum alloy is an aluminum copper alloy.

6 - The device of claim 5 wherein said copper is present in said alloy in an amount of from about .25 to about 2.0 parts by weight of said alloy.

7 - The device of claim 6 wherein said alloy contains about .5 % copper by weight of said alloy.

8 - The device of claim 1 wherein said layer is substantially pure titanium.

9 - The device of claim 1 wherein said layer is substantially pure niobium.

10 - The device of claim 1 wherein said conductive path is substantially silicon free and contains up to about .6 % by weight of the alloy copper, and has a thickness of from about 4000 to 15000 angstroms; and said titanium or niobium layer has a thickness of from about 500 to about 2000 angstroms.

11 - A method for producing a semiconductor device which comprises providing a silicon substrate having circuit elements thereon and an insulating layer over said substrate and circuit elements, which insulating layer has contact openings therethrough corresponding to the circuit elements ; providing a conductive layer of substantially pure titanium or niobium layer on said insulating layer which connect openings ; and forming elements through the said contact openings ; and forming a second conductive layer of aluminum or aluminum alloy on said titanium or niobium layer ; said aluminum being substantially completely separated from said substrate and said insulating layer and said bi-layer is then jointly patterned.

12 - The method of claim 11 wherein said aluminum alloy is substantially silicon free.

13 - The method of claim 11 wherein said titanium or niobium path has a thickness of from about 500 to about 2000 angstroms.

14 - The method of claim 11 wherein said aluminum or aluminum alloy has a thickness of from about 4000 to about 15000 angstroms.

15 - The method of claim 11 wherein said aluminum alloy is an aluminum-copper alloy.

16 - The method of claim 15 wherein said copper is present in said alloy in an amount of from about .25 to above 0.4% by weight of said alloy.

17 - The method of claim 16 wherein said alloy contains about .5 % copper by weight of said alloy.

18 - The method of claim 11 wherein said first conductive layer is substantially pure titanium.

19 - The method of claim 11 wherein said first conductive layer is substantially pure niobium.

20 - The method of claim 11 wherein said second conductive layer is substantially silicon free and contains up to about 0.6 % by weight of the alloy copper, and has a thickness of from about 4000 to 15000 angstroms ; and said titanium or niobium first conductive path has a thickness of from about 500 to about 2000 angstroms.

21 - A method for producing a semiconductor device which comprises providing a silicon substrate having circuit elements thereon and an insulating layer over said substrate and circuit elements, which insulating layer has contact openings therethrough corresponding to the circuit elements ; providing a conductive layer of substantially pure titanium or niobium on said insulating layer which connects with said circuit elements through the said circuit elements through the said contact openings ;

forming a second conductive layer of aluminum or an aluminum alloy on said titanium or niobium layer ; said aluminum layer being substantially completely separated from said substrate and said insulating layer by said titanium or niobium layer ; patterning both conductive layers simultaneously into a desired pattern ; providing a subsequent insulating layer over said conductive pattern ; providing via openings in said insulating layer corresponding to desired elements of said conductive pattern ; providing a second conductive layer of substantially pure titanium or niobium on said second insulating layer which connects with said conductive pattern through said contact openings ; providing a second layer of aluminum or aluminum alloy on said second titanium or niobium layer ; patterning said second layer of aluminum or aluminum alloy over titanium or niobium.

22 - The method of claim 21 where subsequent insulating layers, via openings and conductive patterns of aluminum or aluminum alloys are provided over titanium or niobium.

23 - The method of claim 21 wherein said second aluminum alloy is essentially silicon free.

24 - The method of claim 21 wherein said second titanium or niobium path has a thickness of from about 500 to 2000 angstroms.

25 - The method of claim 21 wherein said aluminum or aluminum alloy has a thickness of from about 4000 to about 15 000 angstroms.

26 - The method of claim 21 wherein said aluminum alloy is an aluminum-copper alloy.

27 - The method of claim 26 wherein said copper is present in said alloy in a mount of from about .25 to about 4.0 % by weight of said alloy.

28 - The method of claim 27 wherein said alloy contains 0.5 % copper by weight of said alloy

29 - The method of claim 21 wherein said lower conductive layer is substantially pure titanium.

30 - The method of claim 21 wherein said lower conductive layer is substantially pure niobium.

31 - The method of claim 21 wherein said second conductive layer is substantially silicon free and contains up to about 0.5% copper by weight of the aluminum alloy, and has a thickness of from about 4000 angstroms to about 15000 angstroms covering a layer of substantially pure titanium with a thickness of from about 500 to about 2000 angstroms.

32 - The method of claim 20, wherein the first conductive layer is substantially pure niobium.

33 - The method of claim 31 wherein the lower conductive layer is substantially pure niobium.

34 - A technique for controlling the surface reflectivity of a thin film of aluminum or aluminum alloy by first depositing a thin layer of niobium then depositing the layer of the aluminum or aluminum alloy.